# EUROPEAN PATENT SPECIFICATION

(11) **EP 4 545 995 B1**
(45) Date of publication and mention of the grant of the patent: **26.08.2026**
(21) Application number: 23863541.1
(22) Date of filing: 07.09.2023
(51) Int. Cl.: G01R 31/396, G01R 31/382, G01R 31/389, G01R 31/392, G01R 31/36, G01D 21/02, G01R 31/367, G01R 31/3842, H02J 7/00, H02J 7/82

(54) **APPARATUS AND METHOD FOR MANAGING BATTERY**
VORRICHTUNG UND VERFAHREN ZUR VERWALTUNG EINER BATTERIE
DISPOSITIF ET PROCÉDÉ PERMETTANT DE GÉRER UNE BATTERIE

(30) Priority: 08.09.2022 KR 20220114042; 05.09.2023 KR 20230117881
(43) Date of publication of application: 30.04.2025
(73) Proprietor: LG Energy Solution, Ltd., Seoul 07335 (KR)
(72) Inventor: PARK, Se-Young, Daejeon 34122 (KR); HONG, Sung-Ju, Daejeon 34122 (KR); KIM, Dong-Hyun, Daejeon 34122 (KR)
(74) Representative: Plasseraud IP
(86) International application number: PCT/KR2023/013461
(87) International publication number: WO 2024/054077

(56) References cited:
- CN-A- 114 981 673
- CN-B- 110 324 383
- KR-A- 20200 107 813
- KR-A- 20210 040 721
- KR-A- 20210 084 079
- KR-A- 20210 141 211
- KR-A- 20220 019 564
- KR-A- 20220 031 411
- KR-A- 20220 031 411
- KR-A- 20220 036 701
- US-A1- 2012 004 873
- US-A1- 2012 025 769
- US-A1- 2018 217 208
- US-A1- 2022 170 988
- US-A1- 2022 268 853

## Description

### TECHNICAL FIELD

The present application claims priority to Korean Patent Application No. 10-2022-0114042 filed on September 8, 2022, in the Republic of Korea and Korean Patent Application No. 10-2023-0117881 filed on September 5, 2023, in the Republic of Korea.

The present disclosure relates to battery management technology, and more specifically, to technology that may efficiently diagnose a battery and thereby improve the performance or protection effect of the battery.

### BACKGROUND ART

Currently commercialized secondary batteries include nickel-cadmium batteries, nickel-hydrogen batteries, nickel-zinc batteries, lithium secondary batteries, and the like. Among them, the lithium secondary batteries are spotlighted because they ensure free charging and discharging due to substantially no memory effect compared to nickel-based secondary batteries, as well as very low discharge rate and high energy density.

Recently, batteries (secondary batteries) have been widely used for driving or energy storage in vehicles such as electric two-wheeled vehicles and electric vehicles medium and large-sized devices such as energy storage systems (ESS). For this reason, the interest in batteries is further increased, and related research and development are being made more actively. Moreover, commercialization and research are being actively conducted on exchangeable public battery packs for electric two-wheeled vehicles and electric vehicles.

The lithium secondary battery mainly uses lithium-based oxide and carbon material as positive electrode active material and negative electrode active material, respectively. Also, the lithium secondary battery includes an electrode assembly in which a positive electrode plate and a negative electrode plate respectively coated with a positive electrode active material and a negative electrode active material are arranged with a separator interposed therebetween, and an exterior material, namely a battery case, for hermetically receiving the electrode assembly together with electrolyte.

In general, lithium secondary batteries may be classified into can-type secondary batteries, in which an electrode assembly is built in a metal can, and pouch-type secondary batteries, in which an electrode assembly is built in a pouch of an aluminum laminate sheet, depending on the shape of the exterior material. Also, can-type secondary batteries may be classified again into prismatic secondary batteries and cylindrical-type secondary batteries, depending on their shape.

A plurality of secondary batteries may be electrically connected to each other and stored together inside a module case (module housing) or a pack case (pack housing) to constitute a battery module or a battery pack. At this time, each secondary battery included in the battery module or the battery pack may be referred to as a battery cell.

To ensure stable performance for batteries in the form of battery cells, battery modules and battery packs, and to protect devices equipped with these batteries and users who use these batteries, it is very important to diagnose the state of the battery and take appropriate measures. As a representative technology for this, a battery pack or ESS may include a control device such as a BMS (Battery Management System) to diagnose the battery and perform related actions.

However, conventionally, by setting a single standard for the measurement values of diagnosis items, the diagnosis results are judged dichotomously, such as a normal state and a failure state, and response routines according to such judgment results are defined. In this case, there is a disadvantage that it is difficult to determine the risk of each part of the battery in advance before the diagnosis measurement value reaches the standard corresponding to the failure state. Also, because of this, it may not be possible to prevent or prepare in advance for the battery to reach a state where the battery is unusable or unrecoverable, such as failure.

US 2022/170988 discloses an apparatus for managing battery with different diagnosis states (see figure 3).

### DISCLOSURE

### Technical Problem

The present disclosure is designed to solve the problems of the related art, and therefore the present disclosure is directed to providing an apparatus and method for managing a battery, which may efficiently diagnose a battery and improve the performance or safety of the battery accordingly, and application devices such as a battery pack including the same.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims.

### Technical Solution

The present invention provides an apparatus for managing a battery as claimed in claim 1, the apparatus comprising: a measurement module configured to measure state information of a battery; and a control module configured to determine a diagnosis step of the battery by comparing the state information measured by the measurement module with a diagnosis criterion of a multistage form and to perform a processing operation corresponding to the determined diagnosis step.

Here, the apparatus for managing a battery may further comprise a memory configured to store the diagnosis criterion of a multistage form.

The control module is configured to classify an abnormal state of the battery into a plurality of diagnosis steps.

In addition, the control module may be configured to determine the diagnosis step for a plurality of diagnosis items.

In addition, the battery may be configured in the form of a battery pack including a plurality of battery cells, and the control module may be configured to perform overvoltage diagnosis and low voltage diagnosis for at least some of the plurality of battery cells or the entire battery pack as the plurality of diagnosis items.

In addition, the control module may be configured to perform diagnosis at charging and diagnosis at discharging for at least one of current and temperature of the battery as the plurality of diagnosis items.

In addition, the control module may be configured to perform inter-cell voltage imbalance diagnosis during charging and inter-cell voltage imbalance diagnosis during idle as the plurality of diagnosis items.

In addition, the control module may be configured to change the diagnosis criterion for at least some of the plurality of diagnosis items according to a diagnosis result of another diagnosis item.

In addition, the measurement module may be configured to change state information measurement time of the battery for at least some of the plurality of diagnosis items according to a diagnosis result of another diagnosis item.

In addition, the control module may be configured to classify the processing operation according to whether automatic release is possible for different diagnosis steps.

The control module is configured to classify the processing operation as output restriction of the battery and output blocking of the battery for different diagnosis steps,
or classify the processing operation as provision of a warning signal and output adjustment for different diagnosis steps.

In another aspect of the present disclosure, there is also provided a battery pack, comprising the apparatus for managing a battery according to the present disclosure.

In still another aspect of the present disclosure, there is also provided a vehicle, comprising the apparatus for managing a battery according to the present disclosure.

In still another aspect of the present disclosure, there is also provided a battery providing system, comprising the apparatus for managing a battery according to the present disclosure.

In still another aspect of the present disclosure, there is also provided a method for managing a battery as claimed in claim 13.

### Advantageous Effects

According to an embodiment of the present disclosure, it is possible to more accurately diagnose a battery by classifying diagnosis criteria in detail, and the monitoring function may be strengthened.

In addition, according to an embodiment of the present disclosure, the performance, safety, and protection effect of the battery may be further improved through processing at each step.

In addition, according to an embodiment of the present disclosure, a preemptive response may be made through diagnosis such as a warning step or a fault step before the battery reaches an unusable or unrecoverable state such as failure. Therefore, it is possible to suppress or delay that the battery itself or a vehicle equipped with such a battery approaches a risk factor such as fault or failure or spreads or expands such a state.

In addition, various other additional effects can be achieved by various embodiments of the present disclosure. The various effects of the present disclosure are explained in detail in each embodiment, or any effects that can be easily understood by those skilled in the art will not be described in detail.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a block diagram schematically showing a functional configuration of an apparatus for managing a battery according to an embodiment of the present disclosure.
FIG. 2 is a diagram schematically showing a multi-stage diagnosis configuration of a control module according to an embodiment of the present disclosure.
FIG. 3 is a diagram schematically showing the multi-stage diagnosis configuration of a control module according to another embodiment of the present disclosure.
FIG. 4 is a table showing examples of diagnosis items by the apparatus for managing a battery according to an embodiment of the present disclosure.
FIGS. 5 and 6 are graphs showing the results of voltage measurement by diagnosis and control according to comparative examples and examples of the present disclosure.
FIG. 7 is a diagram schematically showing a diagnosis criterion changing configuration according to an embodiment of the present disclosure.
FIG. 8 is a diagram schematically showing a diagnosis criterion changing configuration according to another embodiment of the present disclosure.
FIG. 9 is a flowchart for schematically illustrating a method for managing a battery according to an embodiment of the present disclosure.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

This specification may include several embodiments. Here, any features identical or similar to those of other embodiments will not be described in detail, and any distinctive features in each embodiment may be described in detail.

Meanwhile, terms such as '... module' may be used in this specification, but this indicates a logical structural unit and does not necessarily indicate a component that can or must be physically separated.

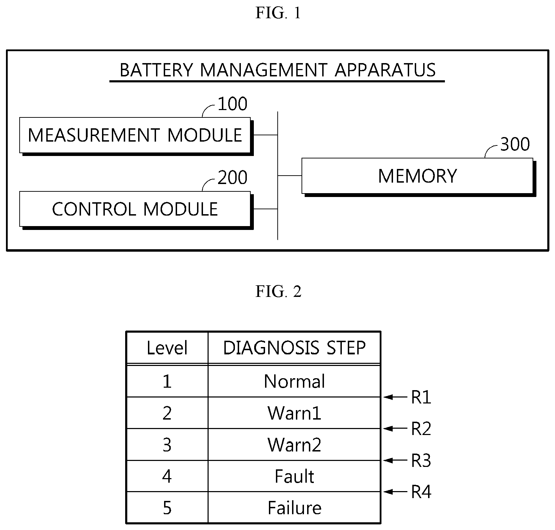

FIG. 1 is a block diagram schematically showing a functional configuration of an apparatus for managing a battery according to an embodiment of the present disclosure.

Referring to FIG. 1, the apparatus for managing a battery according to the present disclosure includes a measurement module 100 and a control module 200.

The measurement module 100 may be configured to measure state information of a battery. Here, the battery may be a concept including a battery cell representing a single secondary battery, a cell group including a plurality of such battery cells, or a battery module, a battery pack, a battery rack, etc.

The state information of the battery may include the internal state and/or external state of the battery. For example, the measurement module 100 may measure information such as the voltage, current, temperature, SOC (State Of Charge), internal resistance, SOH (State Of Health), charging and discharging state, idle state, overvoltage or overcurrent state and balancing state of the battery as the internal state of the battery. For this purpose, the measurement module 100 may include various sensors such as a voltage sensor or a current sensor. As another example, the measurement module 100 may measure state information such as temperature, humidity, smoke, etc. around the battery as the external state of the battery. For this purpose, the measurement module 100 may include sensors such as a temperature sensor, a humidity sensor, and a smoke sensor. In this respect, the measurement module 100 may also be referred to as a sensor.

The measurement module 100 may measure the state information of the battery one-dimensionally by measuring voltage, current, temperature, etc. through sensors. Also, the measurement module 100 may perform two-dimensional processing, such as calculation, on the information obtained one-dimensionally as above. For example, the measurement module 100 may measure the state information of the battery by calculating or estimating the state such as SOC, internal resistance, SOH, and imbalance of the battery based on the state information such as voltage, current, and temperature.

The measurement module 100 may transmit the state information of the battery measured in this way to the control module 200.

The control module 200 may receive the measured state information from the measurement module 100. Also, the control module 200 may perform battery diagnosis and/or control operations using the state information received in this way.

In particular, the control module 200 may be configured to compare the state information measured by the measurement module 100 with a diagnosis criterion. Also, the control module 200 may determine the diagnosis step of the battery based on the comparison result of the measurement information and the diagnosis criterion. In particular, the control module 200 may determine the diagnosis step of the battery as a plurality of diagnosis steps. In other words, the control module 200 may diagnose the battery in multiple stages. This will be described in more detail with additional reference to FIG. 2.

FIG. 2 is a diagram schematically showing a multi-stage diagnosis configuration of the control module 200 according to an embodiment of the present disclosure.

Referring to FIG. 2, the diagnosis step is classified into five steps. More specifically, there are five levels (Levels 1 to 5) and each diagnosis step corresponding to each level is classified as Normal, Warn1, Warn2, Fault, and Failure. Here, Normal, Warn1, Warn2, Fault, and Failure may be referred to or interpreted as normal, warning, danger, fault, and failure, respectively, in that order, but these names or meanings can be modified into various other forms.

The control module 200 may determine a diagnosis step to which the battery (target battery or diagnosis battery), which is a diagnosis target, belongs to among the plurality of diagnosis steps. For example, in the embodiment of FIG. 2, the control module 200 may determine that the diagnosis target battery is in the Warn1 (warning) step of Level 2. Alternatively, in the embodiment of FIG. 2, the control module 200 may determine that the diagnosis target battery is in the Warn2 (danger) step of Level 3.

For the multi-stage diagnosis of the battery, the diagnosis criterion may be configured in a multistage form. Also, through the multistage form of the diagnosis criterion, the multi-stage diagnosis of the battery may be made.

In particular, the diagnosis criterion may have a plurality of reference values. For example, the diagnosis criterion may have two or more reference values. Moreover, the diagnosis criterion may have four or more reference values.

As a more specific example, as in the embodiment of FIG. 2, when the battery is diagnosed in five steps, four diagnosis criteria R1 to R4 may be provided. Here, R1, R2, R3, and R4 may be standards for distinguishing the Normal step and the Warn1 step from each other, distinguishing the Warn1 step and the Warn2 step from each other, distinguishing the Warn2 step and the Fault step from each other, and distinguishing the Fault step and the Failure step from each other, respectively. At this time, each of the reference values R1, R2, R3, and R4 may be a value representing a specific numerical value or a value representing a specific range.

In this way, when the diagnosis criterion has a plurality of reference values in a multistage form, the diagnosis step may be classified into three or more steps. In other words, the number of diagnosis steps may be more than the number of reference values by one. For example, in the embodiment of FIG. 2, since there are four reference values, the diagnosis step may be classified as five steps.

Meanwhile, in the embodiment of FIG. 2, each diagnosis criterion is shown to classify two neighboring diagnosis steps, but this is only an example, and the diagnosis criterion may be provided in various other forms. For example, the diagnosis criterion may be expressed as the range of each diagnosis step. As a more specific example, for specific state information, the diagnosis criterion may be set so that values of 0 to 1 are Level 1 (Normal), values of 1 to 2 are Level 2 (Warn1), and values of 2 to 3 are Level 3 (Warn2), value of 3 to 4 is Level 4 (Fault), and value of 4 or higher is Level 5 (Failure).

In the embodiment of FIG. 2, four diagnosis criteria and five diagnosis steps are shown, but the number of diagnosis criteria or diagnosis steps may be implemented in various other forms. For example, the control module 200 may perform multi-stage diagnosis to four diagnosis steps according to three diagnosis criteria.

When the diagnosis step of the target battery is determined in this way, the control module 200 may be configured to perform a processing operation corresponding to the determined diagnosis step. Here, the corresponding processing operation may be implemented in various forms or ways.

For example, the control module 200 may transmit or store the information about the diagnosis step of the target battery to other components as a processing operation for the diagnosis step of the target battery. For example, if the target battery is diagnosed as being in the Warn1 (warning) step, the control module 200 may transmit the information that the target battery is diagnosed as being in the Warn1 (warning) step to other components.

Here, other components may be a component included within the apparatus for managing a battery according to the present disclosure, or may be a component included in another device existing outside the apparatus for managing a battery. In particular, when the target battery is mounted on a vehicle such as a two-wheeled vehicle, the apparatus for managing a battery may transmit the diagnosis step determined for the target battery to a higher-level control system on the vehicle, such as a VCU (Vehicle Control Unit) or ECU (Energy Control Unit).

The control module 200 may transmit a diagnosis signal of the target battery using various wired or wireless communication configurations or methods. For example, the control module 200 may transmit the information about the determined diagnosis step of the target battery to the control system of the vehicle using CAN (Controller Area Network) communication. The control module 200 may define and transmit the diagnosis signal as a 4-bit signal. However, the diagnosis signal may be defined or communicated in various other ways.

As another example, the control module 200 may be configured to control charging or discharging operations of the battery as a processing operation for the diagnosis step of the target battery. At this time, the control module 200 may directly perform charging and discharging control for the target battery. Alternatively, the control module 200 may indirectly instruct or control another component located inside or outside the apparatus for managing a battery to perform the charging and discharging control. In this case, the control module 200 may transmit the information about the diagnosis step to another component and allow the corresponding component to perform charging and discharging control, etc., as in the former embodiment.

The control module 200 may perform a processing operation for each of the plurality of diagnosis steps. At this time, the control module 200 may be configured to perform different processing operations for each diagnosis step. Also, the control module 200 may perform at least partially the same processing operation for different diagnosis steps. Also, the processing operation by the control module 200 does not necessarily include only active operations and may also include passive operations. In particular, the processing operations by the control module 200 may include not performing any control or communication.

In addition, when the control module 200 directly performs a processing operation of the target battery, the control module 200 may transmit the performed processing result to other components.

According to this embodiment of the present disclosure, the battery may be more accurately diagnosed. Therefore, based on this diagnosis, it is possible to ensure that the battery performs more effectively and/or take prompt action before the battery progresses to a serious situation such as battery damage or unusability. Moreover, interest in the safety of batteries has recently increased, and the present disclosure may contribute to improving the safety of batteries.

In addition, in the present disclosure, diagnosis and management may be possible not only for a single battery cell, but also for units containing a plurality of battery cells, such as a cell assembly, a battery module, a battery pack, a battery rack, and an energy storage system.

In the apparatus for managing a battery according to the present disclosure, the control module 200 may selectively include, at least partially, a processor, a controller, an application-specific integrated circuit (ASIC), other chipsets, logic circuits, registers, a communication modem, a data processing device, etc. known in the art to perform related operations or functions. Also, their operations may be implemented as software, in which case the program may be stored in an internal or external memory. In this respect, the control module 200 may be replaced with terms such as processor, controller, or chipset. Also, at least some functions of the measurement module 100 may also be implemented using these known components.

The control module 200 does not necessarily be physically integrated or located in the same location. For example, some functions of the control module 200 may be performed at the battery pack, and other functions of the control module 200 may be performed at the vehicle.

More specifically, at least a part of the control module 200 may be implemented by a BMS (Battery Management System), which is typically included in a battery pack or ESS. In this case, at least a part of the control module 200 may be implemented as included in a battery (battery pack). Also, at least a part of the control module 200 may be located outside the battery. For example, at least some functions of the control module 200 may be implemented by a control device mounted on the vehicle, such as a VCU or ECU. Also, the measurement module 100 may also be implemented as integrated or separate parts or components.

The apparatus for managing a battery according to the present disclosure may further include a memory 300.

In particular, the memory 300 may store the diagnosis criterion in a multistage form in advance. Also, the control module 200 may access the memory 300 and read the stored diagnosis criterion. In addition, the memory 300 may store various data or programs necessary for each component of the apparatus for managing a battery according to the present disclosure, such as the measurement module 100 and/or the control module 200, to perform its functions.

The memory 300 may be implemented in an integrated form with other components included in the apparatus for managing a battery, such as a component functioning as the control module 200. For example, the memory 300 may be implemented as an internal memory provided to a processor that functions as the control module 200.

The memory 300 has no particular restrictions on the type of storage medium as long as it can record and erase information. For example, the memory 300 may be implemented as a RAM, ROM, register, hard disk, optical recording medium, or magnetic recording medium.

Meanwhile, the diagnosis criterion may be provided from a component that exists outside the apparatus for managing a battery. For example, the diagnosis criterion may be provided to the control module 200 from a higher-level system of the apparatus for managing a battery, such as a vehicle. As another example, the diagnosis criterion may be provided to the control module 200 from a battery providing system communicatively connected to the apparatus for managing a battery, such as a battery charging system or a battery replacement system. In this way, if the diagnosis criterion is provided from the outside of the apparatus for managing a battery, the memory 300 may temporarily store the provided diagnosis criterion. At this time, the memory 300 may be a volatile memory such as RAM.

In particular, the control module 200 may be configured to classify the abnormal state of the battery into a plurality of diagnosis steps. In other words, the control module 200 may be configured to diagnose the battery into a normal state and an abnormal state, but further subdivide the abnormal state into two or more steps.

For example, seeing the embodiment of FIG. 2, the control module 200 may be configured to classify and diagnose the abnormal state, rather than a normal state, into at least two steps among the Warn1 step, the Warn2 step, the Fault step, and the Failure step for the battery. In a more specific example, the control module 200 may classify and diagnose the abnormal state of the battery into four steps (Warn1/Warn2/Fault/Failure). As another example, the control module 200 may be configured to integrate the Warn1 step and the Warn2 step into one Warn step in the embodiment of FIG. 2 to classify and diagnose the abnormal state of the battery into a total of three steps (Warn/Fault/Failure).

Moreover, the plurality of abnormal steps classified and diagnosed by the control module 200 may be classified according to the degree of abnormality. For this purpose, the diagnosis criteria of a multistage form may be arranged in the order of increasing severity of the abnormal situation from the normal state.

For example, in the embodiment of FIG. 2, the Warn1 step, the Warn2 step, the Fault step, and the Failure step may all be diagnosis steps indicating an abnormal condition of the battery. At this time, the Warn1 step may be located immediately after the Normal step. Also, after the Warn1 step, the Warn2 step, the Fault step, and the Failure step may be located sequentially. In other words, the order listed sequentially in the direction gradually moving away from the Normal state is the Warn1 step, the Warn2 step, the Fault step, and the Failure step. In this case, it may be regarded that the Warn1 step represents the state in which the degree of abnormality of the battery is weakest, and the Failure step represents the state in which the degree of abnormality of the battery is most severe.

In this embodiment, the Warn1 step and the Warn2 step may be steps given in a situation that is beyond the normal usage range of the battery but is not serious. Also, the Warn1 step may indicate a situation in which the degree of abnormality is relatively lower than the Warn2 step. In other words, the Warn1 step may be regarded as representing the abnormal state of the earliest step among several abnormal steps.

In addition, although the Warn2 step is more abnormal than the Warn1 step, the Warn2 step may not be severe enough to take serious measures such as blocking the output. For example, the Warn1 step may be a diagnosis step determined when a fault is likely to occur if the battery or related components continuously maintain the corresponding state. Meanwhile, the Warn2 step may be a diagnosis step that is determined when a fault is highly likely to occur if the battery or related components continuously maintain the corresponding state. In this respect, the Warn1 step may be referred to as a warning step, and the Warn2 step may be referred to as a danger step.

Next, the Fault step and the Failure step may be regarded as representing situations in which the degree of abnormality is more severe than the Warn1 step and the Warn2 step. Here, the Fault step may be a diagnosis step determined in a situation in which a fault has already occurred in the battery or related components and thus, if the situation is continuously maintained, a failure is highly likely to occur in the battery or related devices or components.

In particular, the Failure step may be a diagnosis step determined in the most serious situations in which a failure has already occurred in the battery or related components, the battery or the like can no longer be used, the battery or the like cannot be recovered to the Normal state, the use of the battery or the like must be stopped immediately, or inspection at a service center is required. In this respect, the Fault step may be referred to as a fault step, and a failure step may be referred to as a failure step.

As in the embodiment of FIG. 2, the diagnosis criterion may have a plurality of reference values, namely a first reference value R1, a second reference value R2, a third reference value R3, and a fourth reference value R4. At this time, the first reference value R1, the second reference value R2, the third reference value R3, and the fourth reference value R4 may reference values that classify the Normal step and the Warn1 step from each other, classify the Warn1 step and the Warn2 step from each other, classify the Warn2 step and the Fault step from each other, and classify the Fault step and the Failure step from each other. Also, the first reference value R1, the second reference value R2, the third reference value R3, and the fourth reference value R4 may be configured in a form where their values gradually increase or decrease. For example, the numerical value for each reference value may be configured as R1<R2<R3<R4, or R1>R2>R3>R4.

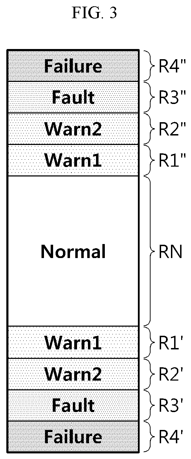

FIG. 3 is a diagram schematically showing the multi-stage diagnosis configuration of a control module 200 according to another embodiment of the present disclosure.

Referring to FIG. 3, the abnormal state of the battery may be located in both directions relative to the Normal state. For example, in FIG. 3, several diagnosis steps are arranged in the vertical direction. At this time, the vertical arrangement of each diagnosis step may be made according to the height of the numerical value. In other words, it may mean that the specific value is higher towards the upper side, and the specific value is lower towards the lower side.

In this case, the Warn1 step, the Warn2 step, the Fault step, and the Failure step may be sequentially placed on both sides of the Normal step, respectively. That is, two Warn1 steps, two Warn2 steps, two Fault steps, and two Failure steps may be placed around the Normal step.

Meanwhile, for the normal state and the abnormal state, a specific numerical range may be set as a diagnosis criterion. For example, seeing the embodiment of FIG. 2, the diagnosis criterion is in the form of a specific range, such as RN, R1', R1", R2', R2", R3', R3", R4', and R4" may be set. At this time, R1', R2', R3', and R4' may be ranges with lower values than RN. Meanwhile, R1", R2", R3", and R4" may be ranges with values higher than RN.

In this embodiment, if the values of specific diagnosis items fall outside the range indicated by RN, the control module 200 may diagnose the battery as being in an abnormal state. Also, the control module 200 may classify and diagnose which step the abnormal state of the battery corresponds to.

For example, if the values of specific diagnosis items are determined to fall within the range indicated by R1' or R1", the control module 200 may diagnose that the corresponding battery is in the Warn1 step. As another example, if the values of specific diagnosis items are determined to fall within the range indicated by R3' or R3", the control module 200 may diagnose that the corresponding battery is in the Fault step.

According to this embodiment of the present disclosure, since diagnosis is performed in several steps depending on the degree of abnormality of the battery, the abnormal state of the battery may be more accurately and minutely diagnosed, which allows more effective response measures to be taken. In particular, according to this embodiment of the present disclosure, the abnormality of the battery may be diagnosed step by step before reaching a serious failure state, such as the Failure step, and preliminary action may be made through such diagnosis. Also, in this case, abnormal situations in the battery may be continuously monitored, and appropriate corresponding measures may be taken to prevent, suppress, or delay the battery from reaching a serious situation such as the Fault step or the Failure step.

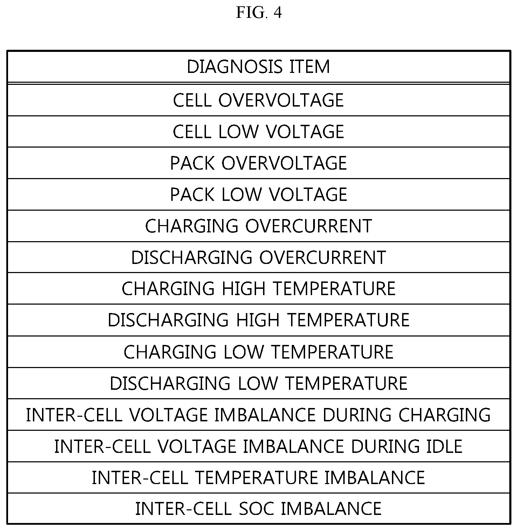

The control module 200 may be configured to determine a diagnosis step for a plurality of diagnosis items. This will be described in more detail with additional reference to FIG. 4.

FIG. 4 is a table showing examples of diagnosis items by the apparatus for managing a battery according to an embodiment of the present disclosure.

Referring to FIG. 4, the control module 200 may perform battery diagnosis on a variety of diagnosis items. For example, in FIG. 4, 14 diagnosis items are included, and the control module 200 may be configured to perform battery diagnosis for all or some of these diagnosis items. In particular, the plurality of diagnosis items may include diagnoses related to voltage, current, temperature, balancing, etc. of the battery.

The control module 200 may perform multi-stage diagnosis for each of the plurality of diagnosis items. For example, for each of the voltage, current, and temperature of the battery, abnormal situations may be diagnosed in multiple stages, like the Warn1 step, the Warn2 step, the Fault step, and the Failure step.

Alternatively, the control module 200 may diagnose some items among the plurality of diagnosis items into a different number of steps, compared to other diagnosis items. For example, for diagnosis items related to voltage and current of the battery, the abnormal state may be determined into four diagnosis steps, and for diagnosis items related to temperature of the battery, the abnormal state may be determined into three diagnosis steps.

According to the above embodiments, more accurate and effective diagnosis and response may be possible by diagnosing each of the various diagnosis items that determine the state of the battery into a plurality abnormal states. Moreover, in this case, abnormal diagnosis or response to the battery may be made more quickly or efficiently.

More specifically, as shown in FIG. 4, the diagnosis items may include cell overvoltage diagnosis. The cell overvoltage diagnosis may be performed in the form of diagnosing whether the voltage for one or more battery cells is in a state higher than the normal state. In particular, when a plurality of battery cells are included in a battery module, a battery pack, a battery rack, etc., the voltage may be measured for each of the plurality of battery cells, and the highest voltage among them may be selected as a maximum voltage. In addition, the cell overvoltage diagnosis may be performed by diagnosing whether the selected maximum voltage is in an overvoltage state higher than the normal voltage state (diagnosis criterion).

In addition, the diagnosis items may include cell low voltage diagnosis. The cell low voltage diagnosis may be performed in the form of diagnosing whether the voltage for one or more battery cells is in a state lower than the normal state. In particular, when a plurality of battery cells are included, the voltage may be measured for each of the plurality of battery cells, and the lowest voltage among them may be selected as a lowest voltage. Also, the cell low voltage diagnosis may be performed by diagnosing whether the selected lowest voltage is in a low voltage state lower than the normal voltage state (diagnosis criterion).

In addition, the diagnosis items may include pack overvoltage diagnosis. The pack overvoltage diagnosis may be diagnosing whether the voltage of a battery pack containing a plurality of battery cells is in a state higher than the normal state. Here, the voltage of the battery pack may mean the voltage at a pack terminal of the battery pack or an average voltage for several battery cells included in the battery pack. For example, the pack overvoltage diagnosis may be performed by calculating an average cell voltage for the plurality of battery cells and diagnosing whether the calculated average cell voltage is in an overvoltage state higher than the normal voltage state (diagnosis criterion). The pack overvoltage diagnosis may be referred to as cell average overvoltage diagnosis when overvoltage is diagnosed with respect to the average voltage of the entire battery cells.

Meanwhile, in this specification, the term 'battery pack' refers not only to a battery pack in which a plurality of battery cells are stored in a pack housing in a narrow sense, but also conceptually refers to a battery module inside the battery pack or a battery rack containing a plurality of battery modules or battery packs stored in a broad sense. In this specification, unless otherwise specified, the 'battery pack' may be interpreted in this broad sense.

In addition, the diagnosis items may include pack low voltage diagnosis. The pack low voltage diagnosis may be diagnosing whether the voltage of a battery pack containing a plurality of battery cells is in a state lower than the normal state. As previously explained, the voltage of the battery pack may refer to the voltage at the pack terminal or the cell average voltage. Moreover, when it is diagnosed whether the cell average voltage is in a state lower than the normal voltage range (diagnosis criterion), the pack low voltage diagnosis may also be referred to as cell average low voltage diagnosis.

In this embodiment, when overvoltage or low voltage is diagnosed based on voltage, the measurement module 100 may include a voltage sensor. Also, the voltage information measured by the voltage sensor may be transmitted to the control module 200 as the state information of the battery. Also, the control module 200 may diagnose an overvoltage or low voltage state for the battery cell or the battery pack based on the voltage information of the battery cell or the battery pack transmitted from the voltage sensor.

In addition, the diagnosis items may include charging overcurrent diagnosis. The charging overcurrent diagnosis may be to diagnose whether the charging current is in a state higher than the normal state in a situation where a battery cell or a battery pack is being charged. At this time, the charging current for which overcurrent is diagnosed may be the current flowing in at least one battery cell or the current flowing in the entire battery pack. For example, when a battery pack containing a plurality of battery cells is charged, the largest current among the currents of the battery cells is determined as a maximum charging current, and it may be diagnosed whether the maximum charging current is in a state higher than the normal current range (diagnosis criterion).

In addition, the diagnosis items may include discharging overcurrent diagnosis. The discharging overcurrent diagnosis may be to diagnose whether the discharging current is in a state higher than the normal state in a situation where a battery cell or a battery pack is being discharged. At this time, the discharging current for which overcurrent is diagnosed may be the current flowing in at least one battery cell or the current flowing in the entire battery pack. For example, when a battery pack containing a plurality of battery cells is discharged, the largest current among the currents of the battery cells is determined as a maximum discharging current, and it may be diagnosed whether the maximum discharging current is in a state higher than the normal current range (diagnosis criterion).

In this embodiment, when overcurrent is diagnosed based on current, the measurement module 100 may include a current sensor. Also, the current information measured by the current sensor may be transmitted to the control module 200 as the state information of the battery. In addition, the control module 200 may diagnose the overcurrent state for the battery cell or the battery pack based on the current information of the battery cell or the battery pack transmitted from the current sensor.

In addition, the diagnosis items may include charging high-temperature diagnosis. The charging high-temperature diagnosis may be to diagnose whether the temperature is in a state higher than the normal state when a battery cell or a battery pack is charged.

Moreover, if the battery pack includes a plurality of battery cells, the temperature for the plurality of battery cells may be measured during charging, and the highest temperature among the several measured temperatures may be determined as a maximum temperature during charging. Also, the charging high-temperature diagnosis may be performed by whether the maximum temperature at the time of charging is in a state higher than the normal temperature range (diagnosis criterion).

Alternatively, the charging high-temperature diagnosis may be performed by measuring the temperature of several battery cells during charging and comparing an average value of several temperature measurement values with the normal temperature range. Alternatively, the charging high-temperature diagnosis may be diagnosed based on whether the highest temperature measurement value among temperature measurement values measured at different time points during charging is higher than the normal temperature range.

In addition, the diagnosis items may include discharging high-temperature diagnosis. The discharging high-temperature diagnosis may be to diagnose whether the temperature is in a state higher than the normal state when a battery cell or a battery pack is discharged.

Moreover, if the battery pack includes a plurality of battery cells, the temperature for the plurality of battery cells may be measured during discharging, and the highest temperature among the several measured temperatures may be determined as a maximum temperature during discharging. Also, the discharging high-temperature diagnosis may be performed based on whether the maximum temperature at the time of discharging is in a state higher than the normal temperature range (diagnosis criterion).

Alternatively, the discharging high-temperature diagnosis may be performed by measuring the temperature of several battery cells during discharging and comparing an average value of several temperature measurement values with the normal temperature range. Alternatively, the discharging high-temperature diagnosis may be performed based on whether the highest temperature measurement value among temperature measurement values measured at different time points during discharging is in a state higher than the normal temperature range.

In addition, the diagnosis items may include charging low-temperature diagnosis. The charging low-temperature diagnosis may be to diagnose whether the temperature is in a state lower than the normal state when a battery cell or a battery pack is charged.

Moreover, when the temperature for a plurality of battery cells is measured during charging, the lowest temperature among several measured temperatures may be determined as a lowest temperature during charging. Also, the charging low-temperature diagnosis may be performed based on whether the lowest temperature at the time of charging is in a state lower than the normal temperature range (diagnosis criterion).

Alternatively, the charging low-temperature diagnosis may be performed by measuring the temperature of several battery cells during charging and comparing an average value of several temperature measurement values with the normal temperature range. Alternatively, the charging low-temperature diagnosis may be performed based on whether the lowest temperature measurement value among temperature measurement values measured at different time points during charging is in a state lower than the normal temperature range.

In addition, the diagnosis items may include discharging low-temperature diagnosis. The discharging low-temperature diagnosis may be to diagnose whether the temperature is in a state lower than the normal state when a battery cell or a battery pack is discharged.

Moreover, when the temperature for a plurality of battery cells is measured during discharging, the lowest temperature among several measured temperatures may be determined as a lowest temperature during discharging. Also, the discharging low-temperature diagnosis may be performed based on whether the lowest temperature at the time of discharging is in a state lower than the normal temperature range (diagnosis criterion).

Alternatively, the discharging low-temperature diagnosis may be performed by measuring the temperature of several battery cells during discharging and comparing an average value of several temperature measurement values with the normal temperature range. Alternatively, the discharging low-temperature diagnosis may be performed based on whether the lowest temperature measurement value among temperature measurement values measured at different time points during discharging is in a state higher than the normal temperature range.

In this embodiment, when high-temperature or low-temperature is diagnosed based on temperature, the measurement module 100 may include a temperature sensor such as a thermistor. At this time, the temperature sensor may be located on the outer or inner surface of a battery cell or a battery pack, or in an outer or inner space, to measure the surrounding temperature.

The temperature information measured by the temperature sensor may be transmitted to the control module 200 as the state information of the battery. Also, the control module 200 may diagnose the high-temperature/low-temperature state for the corresponding battery cell or battery pack based on the temperature information of the battery cell or battery pack transmitted from the temperature sensor.

In addition, the diagnosis items may include inter-cell voltage imbalance diagnosis during charging. The inter-cell voltage imbalance diagnosis during charging may be to diagnose whether imbalance occurs in a plurality of battery inter-cell voltages when a battery pack containing a plurality of battery cells or the like is charged.

In addition, the diagnosis items may include inter-cell voltage imbalance diagnosis during idle. The inter-cell voltage imbalance diagnosis during idle may be to diagnose whether imbalance occurs in a plurality of battery inter-cell voltages in an idle section where a battery pack containing a plurality of battery cells or the like is not charged or discharged.

The inter-cell voltage imbalance diagnosis during charging or idle may be performed by the control module 200 by comparing voltages for a plurality of battery cells based on the voltage measurement information transmitted from a voltage sensor. For example, the control module 200 may diagnose the inter-cell voltage imbalance state by calculating a plurality of battery inter-cell voltage differences and determining whether the calculated voltage difference deviates from a standard voltage difference that is the diagnosis criterion or how much the calculated voltage difference deviates.

In addition, the diagnosis items may include inter-cell temperature imbalance diagnosis. The inter-cell temperature imbalance diagnosis may be to diagnose whether battery inter-cell temperature imbalance occurs during operation of the battery pack in a configuration in which a plurality of battery cells are included in the battery pack or the like.

In this embodiment, a temperature sensor may be provided as the measurement module 100 to measure the temperature of a plurality of battery cells. Also, the measured temperature information of each battery cell may be transmitted to the control module 200 as the state information of the battery. Then, the control module 200 may diagnose the temperature imbalance state by comparing the temperatures of the cells transmitted as above. For example, the control module 200 may diagnose the inter-cell temperature imbalance state by calculating a plurality of battery inter-cell temperature differences and determining whether the calculated temperature difference deviates from the standard temperature difference that is the diagnosis criterion how much the calculated temperature difference deviate.

In addition, the diagnosis items may include inter-cell SOC (State Of Charge) imbalance diagnosis. The inter-cell SOC imbalance diagnosis may be to diagnose whether imbalance occurs in the battery inter-cell SOC when the battery pack operates in a configuration in which a plurality of battery cells are included in the battery pack or the like.

In this embodiment, a voltage sensor and/or a current sensor is provided as the measurement module 100, so that voltage or current for a plurality of battery cells may be measured and transmitted to the control module 200. Also, the control module 200 may calculate the SOC of each cell based on the transmitted voltage or current information. Also, the control module 200 may diagnose the inter-cell SOC imbalance state by comparing the SOC of each cell calculated in this way. For example, the control module 200 may diagnose the inter-cell SOC imbalance state by calculating a plurality of battery inter-cell SOC differences and determining whether the calculated SOC difference deviates from the standard SOC difference, which is the diagnosis criterion, and how much the calculated SOC difference deviates.

The control module 200 may diagnose all or at least one diagnosis item among the plurality of diagnosis items as shown in FIG. 4.

In particular, when the battery is configured in the form of a battery pack including a plurality of battery cells, the control module 200 may be configured to perform overvoltage diagnosis and low voltage diagnosis for at least some of the plurality of battery cells or the entire battery pack as the plurality of diagnosis items. For example, the control module 200 may perform at least the cell overvoltage diagnosis, the cell low voltage diagnosis, the pack overvoltage diagnosis, and the pack low voltage diagnosis among the plurality of diagnosis items shown in FIG. 4.

In this embodiment, the measurement module 100 may include a voltage sensor to measure the voltage of the battery cell and the battery pack and transmit the measured voltage information to the control module 200. Then, the control module 200 may diagnose both the overvoltage state and the low voltage state for the battery cell and the battery pack based on the voltage information transmitted from the measurement module 100.

In addition, the control module 200 may perform a corresponding operation based on the result of the diagnosis. For example, when overvoltage or low voltage is diagnosed for the battery cell or battery pack, the control module 200 may transmit a diagnosis signal containing the diagnosis information to a higher-level system such as a vehicle.

In addition, the control module 200 may be configured to perform diagnosis at charging and diagnosis at discharging for at least one of the current and temperature of the battery, as the plurality of diagnosis items.

For example, the control module 200 may perform at least the charging overcurrent diagnosis and the discharging overcurrent diagnosis among the plurality of diagnosis items shown in FIG. 4. Also, the control module 200 may perform the charging high-temperature diagnosis, the discharging high-temperature diagnosis, the charging low-temperature diagnosis, and the discharging low-temperature diagnosis among the plurality of diagnosis items shown in FIG. 4.

In this embodiment, the measurement module 100 may include a current sensor and/or a temperature sensor and transmit the measured current or temperature information to the control module 200. In this case, the control module 200 may diagnose the overcurrent state, the high-temperature state, the low-temperature state, etc. for the battery cell or battery pack, etc., based on the current or temperature information transmitted from the measurement module 100.

In particular, the control module 200 may perform both the diagnosis at charging and the diagnosis at discharging when diagnosing states such as overcurrent, high-temperature, or low-temperature. In this embodiment, the control module 200 may perform more accurate and detailed battery diagnosis by performing comprehensive state diagnosis in consideration of the results of both the diagnosis at charging and the diagnosis at discharging.

In addition, the control module 200 may be configured to perform inter-cell voltage imbalance diagnosis during charging and inter-cell voltage imbalance diagnosis during idle, as the plurality of diagnosis items. For example, the control module 200 may perform at least the inter-cell voltage imbalance diagnosis during charging and the inter-cell voltage imbalance diagnosis during idle among the plurality of diagnosis items shown in FIG. 4.

In this embodiment, the measurement module 100 may include a voltage sensor or a current sensor to measure voltage or current for several battery cells. In particular, the measurements may be performed both in the charging and idle situations of the battery pack. Also, the measurement information may be transmitted to the control module 200, so that the control module 200 may diagnose the inter-cell voltage imbalance state during charging and idle, respectively. Also, the control module 200 may transmit a diagnosis signal including the diagnosis information to a higher-level system such as a vehicle.

In addition, the diagnosis items may include additional or alternative items other than the various items described above with reference to FIG. 4.

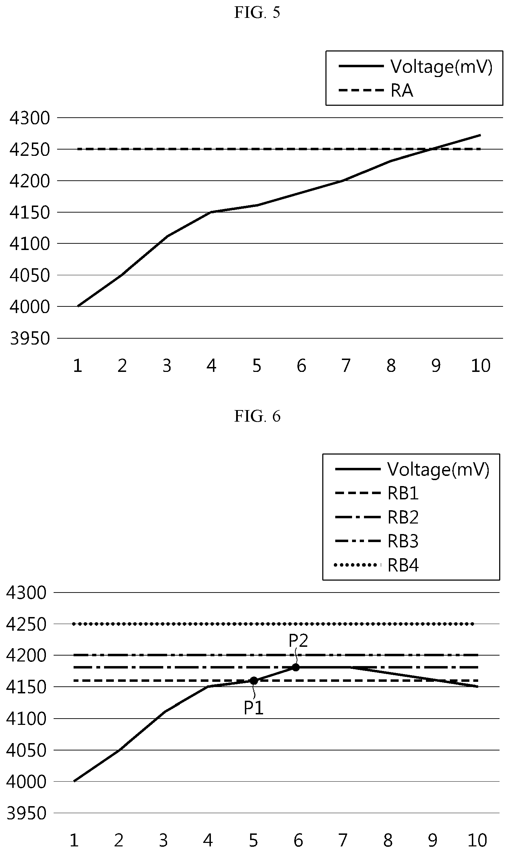

The control module 200 may determine the diagnosis step in multiple stages for at least one of the plurality of diagnosis items. Also, the control module 200 may perform corresponding control operations according to the diagnosis results for the diagnosis items. This will be described in more detail with additional reference to FIGS. 5 and 6.

FIGS. 5 and 6 are graphs showing the results of voltage measurement by different diagnosis and control for the same kind of batteries. In particular, FIG. 6 is data of an example to which the battery management technology according to an embodiment of the present disclosure is applied, and FIG. 5 is data of a comparative example to which the battery management technology according to the present disclosure is not applied in order to be compared with the data of the above example. Moreover, FIGS. 5 and 6 may be the results of cell overvoltage diagnosis.

In the graphs of FIGS. 5 and 6, the vertical axis is a voltage axis and may have units of [mV], and the horizontal axis may represent a measurement cycle. Alternatively, the horizontal axis may be expressed as time, SOC, charged capacity, etc.

First, referring to FIG. 5 according to the comparative example, only one reference value is set as indicated by RA for the voltage measurement value. This reference value is set at approximately 4250 mV and may classify the Failure state.

In this embodiment of FIG. 5, it is possible to determine only whether the battery is in a failure state or not through the single reference value RA. Therefore, if the measured voltage of the battery exceeds 4250 mV, the battery may be diagnosed as in a failure state, and if the measured voltage of the battery does not exceed 4250 mV, the battery may be diagnosed as in a normal state. In this configuration, no action is taken until the measured voltage reaches the failure state of 4250 mV. For example, if the measurement voltage of the battery is 4230 mV, the battery is diagnosed as being in a normal state, so no special measures may be taken. Therefore, according to this embodiment, battery failure cannot be prevented or suppressed in advance.

Meanwhile, referring to FIG. 6 according to an embodiment of the present disclosure, a plurality of reference values are set for overvoltage diagnosis of the battery. For example, the plurality of reference values may be set as four values, as indicated by RB1, RB2, RB3, and RB4 in FIG. 6. Here, the four reference values are diagnosis criteria for diagnosing the abnormal state of the battery and may have different values. In particular, it may have gradually higher values from RB1 to RB4. In this case, the diagnosis level for the abnormal state of the battery may be regarded as having four steps.

In this embodiment, RB4 may be set to approximately 4250 mV, similar to the reference value set to RA in FIG. 5. In other words, RB4 may be a diagnosis criterion for classifying the Failure state of the battery. Also, RB3 has a lower value than RB4, for example 4200 mV, and may be a diagnosis criterion for classifying the Fault state before battery failure. Also, RB2 has a lower value than RB3 and may be a diagnosis criterion that classifies the danger (Warn2) state before battery failure. Also, RB1 has a lower value than RB2 and may be a diagnosis criterion that classifies the warning (Warn1) state before battery danger.

The plurality of diagnosis criteria for multi-stage diagnosis as shown in FIG. 6 may be reflected through source code modification for the diagnosis part in the software of the control module 200. Also, the control module 200 may perform step-by-step processing routines after the multi-stage diagnosis.

For example, as indicated by P1 in the embodiment of FIG. 6, when the voltage measurement value reaches RB1 during charging of the battery, the control module 200 may transmit a warning signal to a higher-level system or display the warning signal to the user as a corresponding processing operation. After that, if the measured voltage reaches RB2 as indicated by P2 as the charging of the battery continues, the control module 200 may suppress the increase of voltage of the corresponding battery by restricting or reducing the charging current for the corresponding battery as a corresponding processing operation. Therefore, the voltage of the battery may be prevented from reaching not only the failure step indicated by RB4 but also the fault step indicated by RB3. Therefore, in this case, it is possible to prevent the state of the battery from deteriorating to battery failure or a step close thereto, or the speed of deterioration may be delayed.

In FIG. 6, an embodiment in which multi-stage (four-stage) diagnosis is performed for cell overvoltage is described, but such multi-stage diagnosis and processing operation for each step may also be performed for various other diagnosis items. For example, the control module 200 may perform the multi-stage diagnosis and processing operation on all or at least two of the plurality of diagnosis items shown in FIG. 4.

In addition, in order to provide the diagnosis result to the user, the control module 200 may directly include a display unit or may provide related data through an external display device. For example, the control module 200 may transmit the diagnosis result to a system at the vehicle, and the vehicle may provide the diagnosis result to occupants through a vehicle monitor.

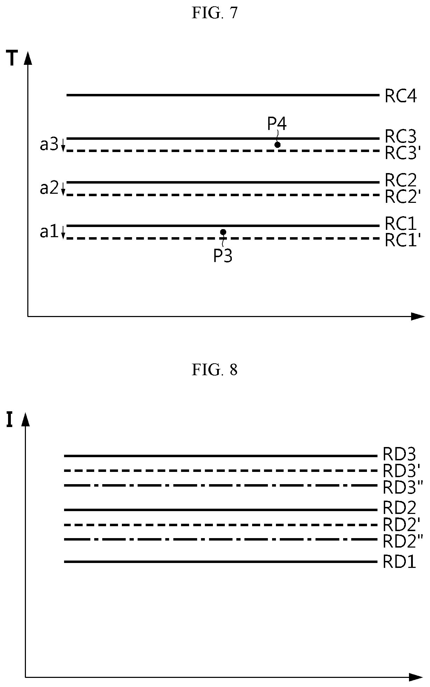

The control module 200 may be configured to change the diagnosis criterion provided for multi-stage diagnosis. In particular, when the control module 200 performs diagnosis and control according to the plurality of diagnosis criteria, the range or value for all or some of the plurality of diagnosis criteria may be changed. This embodiment will be described in more detail with further reference to FIG. 7 and the like.

FIG. 7 is a diagram schematically showing a diagnosis criterion changing configuration according to an embodiment of the present disclosure. In FIG. 7, the vertical axis may represent temperature, and the horizontal axis may represent measurement rounds or time, etc. as shown in FIG. 6.

Referring to FIG. 7, in order to diagnose temperature of the battery, four diagnosis criteria RC1, RC2, RC3, RC4 may be provided. For example, FIG. 7 may show diagnosis criteria related to charging high-temperature diagnosis among the diagnosis items in FIG. 4. Here, RC4 may have the highest temperature value, and RC1 may have the lowest temperature value. At this time, the control module 200 may change one or more of the four diagnosis criteria.

For example, the control module 200 may change three diagnosis criteria RC1, RC2, RC3 among the four diagnosis criteria. More specifically, the control module 200 may change the first diagnosis criterion RC1 for classifying the warning (Warn1) step to a new diagnosis criterion RC1' by moving the first diagnosis criterion RC1 downwards as indicated by arrow a1. Also, the control module 200 may change the second diagnosis criterion RC2 for classifying the danger (Warn2) step to a new diagnosis criterion RC2' by moving the second diagnosis criterion RC2 downwards as indicated by arrow a2. Also, the control module 200 may change the third diagnosis criterion RC3 for classifying the Fault step to a new diagnosis criterion RC3' by moving the third diagnosis criterion RC3 downwards as indicated by arrow a3.

If the diagnosis criterion changes like this, the abnormal diagnosis result for temperature may change. For example, in the embodiment of FIG. 7, when the measured temperature of the battery corresponds to P3, before the diagnosis criterion changes, since P3 has a value smaller than the first diagnosis criterion RC1, the control module 200 may determine that the battery high-temperature diagnosis is in a normal state. However, after the diagnosis criterion changes, the first diagnosis criterion is changed to RC1', and the measurement temperature P3 is higher than RC1'. Therefore, the control module 200 may diagnose that the charging high-temperature diagnosis of the battery is in the warning (Warn1) step, which is one of the abnormal states.

In particular, when diagnosing a plurality of diagnosis items, the control module 200 may change the diagnosis criterion for at least some diagnosis items according to the diagnosis result of another diagnosis item. Moreover, when another diagnosis item is diagnosed as in a specific abnormal step, the control module 200 may change the diagnosis criterion for the corresponding diagnosis item.

For example, the control module 200 may change the diagnosis criterion of the high-temperature diagnosis item as shown in FIG. 7 according to the diagnosis results for the overvoltage diagnosis item as shown in FIG. 6. As a more specific example, if a specific battery cell is diagnosed as in the danger (Warn2) step during cell overvoltage diagnosis, the control module 200 may change the diagnosis criterion as shown in FIG. 7 during the high-temperature diagnosis, which is another diagnosis item for the corresponding battery cell.

The control module 200 may change the reference value upwards or downwards when changing the diagnosis criterion.

In particular, for an item that is diagnosed as abnormal when the measurement value is higher than the diagnosis criterion, if the diagnosis result of another diagnosis item is abnormal, the reference value that becomes the diagnosis criterion may be lowered, as shown in FIG 7. For example, diagnosis items such as the cell overvoltage diagnosis, the pack overvoltage diagnosis, the charging and discharging overcurrent diagnosis, and the charging and discharging high-temperature diagnosis may be applied thereto.

In addition, for an item that is diagnosed as abnormal when the measurement value is lower than the diagnosis criterion, such as the cell low voltage, the pack low voltage, the charging and discharging low-temperature, etc., if the diagnosis result of another diagnosis item is abnormal, the reference value that becomes the diagnosis criterion may be increased.

According to this embodiment of the present disclosure, when another diagnosis item is diagnosed as abnormal, the abnormal diagnosis criterion of a specific diagnosis item may be lowered or relaxed to enable more rapid diagnosis and preemptive treatment on the abnormal situation. In particular, if an abnormality occurs in the battery, various diagnosis items are highly likely to be diagnosed as abnormal. For example, diagnosis items related to voltage, current, and temperature are highly related to each other, so if one of them is diagnosed as abnormal, other items are also highly likely to be diagnosed as abnormal.

However, there may be a time difference in abnormal diagnosis for these various diagnosis items. According to this embodiment, if a specific diagnosis item is diagnosed as abnormal, it is possible to more quickly identify the state of another diagnosis item that is highly likely to become abnormal. Therefore, in this case, the relevant response may be made more quickly.

For example, in the embodiment of FIG. 7, when the measured temperature of the battery corresponds to P4, before the diagnosis criterion changes, P4 is higher than the second diagnosis criterion RC2 but lower than the third diagnosis criterion RC3, so the battery may be diagnosed just in the danger (Warn2) step. However, if another diagnosis item, such as the charging overcurrent diagnosis item, is diagnosed to be in at least one of the abnormal steps so that the charging high-temperature diagnosis criterion is adjusted downward as indicated by arrows a1 to a3 in FIG. 7, the measured temperature P4 may be regarded as being higher than a new third diagnosis criterion RC3'. Therefore, the control module 200 may diagnose the corresponding battery as being in the Fault step in the charging high-temperature item and perform more active and strengthened response operations. Therefore, in this case, more active and rapid action may be made on the charging high-temperature item.

Meanwhile, in the embodiment of FIG. 7, the embodiment that can be applied to charging high-temperature diagnosis or discharging high-temperature diagnosis has been described in detail, but the change in diagnosis criterion can also be applied to various other diagnosis items. For example, this change of diagnosis criterion may be applied to all of 14 diagnosis items shown in FIG. 4.

As in the embodiment of FIG. 7, the control module 200 may consider not only the diagnosis result of one diagnosis item but also the diagnosis results of several diagnosis items when changing the diagnosis criterion. For example, during the cell overvoltage diagnosis, the control module 200 may change the diagnosis criterion by considering the pack overvoltage diagnosis result, the charging overcurrent diagnosis result, the charging high-temperature diagnosis result, etc. As another example, during the cell low voltage diagnosis, the control module 200 may change the diagnosis criterion by considering the pack low voltage diagnosis result, the discharging low-temperature diagnosis result, etc. together.

Meanwhile, in the embodiment of FIG. 7, it is shown that each diagnosis criterion is changed only once, but the present disclosure is not limited to this embodiment. In particular, the control module 200 may change at least one diagnosis criterion by two levels or more. This will be described in more detail with further reference to FIG. 8 and the like.

FIG. 8 is a diagram schematically showing a diagnosis criterion changing configuration according to another embodiment of the present disclosure. In FIG. 8, the vertical axis may represent current, and the horizontal axis may represent measurement rounds or time, etc. as shown in FIG. 6.

Referring to FIG. 8, for diagnosis of current of the battery, such as charging overcurrent diagnosis, three diagnosis criteria RD1, RD2, RD3 may be provided. In this case, the overcurrent diagnosis of the battery may classify and diagnose the abnormal state in three steps. Here, RD3 has the highest current value and may be a diagnosis criterion that classifies the Failure step. Also, RD2 may be a diagnosis criterion that classifies the Fault step, and RD1 may be a diagnosis criterion that classifies the integrated warning (Warn) step, respectively.

For example, in the embodiment of FIG. 8, the control module 200 may change the diagnosis criterion RD3 to RD3' or RD3", depending on the diagnosis result of another diagnosis item. Alternatively, the control module 200 may firstly change RD3 to RD3' according to the diagnosis result of another diagnosis item, and then secondarily change RD3' to RD3" when a certain condition is met.

As shown in FIG. 8, in an embodiment where the diagnosis criterion may be changed to several levels, the change level of the diagnosis criterion may be determined by considering an abnormal step in another diagnosis item. Moreover, the control module 200 may be configured to further increase the change level in the diagnosis criterion when the abnormal state of another diagnosis item is relatively more serious.

For example, in the embodiment shown in FIG. 6, when the cell overvoltage diagnosis is diagnosed as the danger (Warn2) step, the control module 200 may lower the diagnosis criteria RD2 and RD3 for fault and failure to RD2' and RD3' for the charging overcurrent diagnosis shown in FIG. 8. Meanwhile, when the diagnosis for the cell overvoltage diagnosis item in FIG. 6 is changed from the danger (Warn2) step to the fault (Fault) step, the control module 200 may further lower the diagnosis criteria RD2' and RD3' to RD2" and RD3" for the charging overcurrent diagnosis in FIG. 8. The finally changed diagnosis criteria RD2" and RD3" are lowered by 2 steps compared to the initial diagnosis criteria RD2 and RD3 and may have been changed to a greater level than RD2' and RD3'.

In addition, during the cell overvoltage diagnosis of FIG. 6, the fault (Fault) step may be diagnosed immediately without going through the danger (Warn2) step. In this case, the control module 200 may directly lower the diagnosis criteria from RD2 and RD3 to RD2" and RD3" for the charging overcurrent diagnosis item of FIG. 8. In other words, each diagnosis criterion may be changed to several levels, and the control module 200 may change the diagnosis criterion sequentially according to the level or change the diagnosis criterion to skip a specific level.

As another example, in an embodiment in which the diagnosis criterion is changed in multiple steps as shown in FIG. 8, the change step may be determined by considering the diagnosis results of several other diagnosis items together. For example, in relation to FIG. 8, during the charging overcurrent diagnosis, the diagnosis criterion may be changed by considering several other diagnosis items such as the cell overvoltage diagnosis item, the pack overvoltage diagnosis item, the charging high-temperature diagnosis item, and the inter-cell voltage imbalance diagnosis item during charging together.

In particular, the control module 200 may determine the change level of the diagnosis criterion for the charging overcurrent diagnosis item of FIG. 8, depending on the number of diagnosed abnormal states among various other diagnosis items. As a more specific example, when an abnormal diagnosis of warning (Warn1) or higher is received in two or less diagnosis items among various other diagnosis items, the control module 200 may change the diagnosis criteria for the fault and failure steps in FIG. 8 from RD2 and RD3 to RD2' and RD3', respectively. Meanwhile, among other diagnosis items, when an abnormal diagnosis of warning or higher is received in more than 3 diagnosis items, the control module 200 may change the diagnosis criteria for the fault and failure steps in FIG. 8 from RD2 and RD3 or RD2' and RD3' to RD2" and RD3".

In addition, the control module 200 may restore the diagnosis criterion to the previous level when a certain condition is met. For example, in the embodiment of FIG. 8, after the diagnosis criteria for the fault and failure steps are changed from RD2' and RD3' to RD2" and RD3", if the abnormal state for another diagnosis item is released or alleviated, the control module 200 may revert the diagnosis criteria from RD2" and RD3" to RD2' and RD3'.

According to this embodiment of the present disclosure, by adaptively changing the diagnosis criterion according to the diagnosis result of another diagnosis item, more accurate and efficient diagnosis and response may be made to an abnormal situation in the battery.

The control module 200 may change the diagnosis criterion according to the change speed of the battery state information measured by the measurement module 100. In particular, the control module 200 may strengthen the diagnosis criterion when the change speed of the battery state information is at a certain level or higher. Here, strengthening the diagnosis criterion may mean lowering the diagnosis criterion for the abnormal state so that the same measurement result can be more easily diagnosed as an abnormal state.

For example, in the charging high-temperature diagnosis item of FIG. 7, if three diagnosis criteria RC1, RC2, and RC3 are lowered to RC1', RC2', and RC3', it may be regarded as the diagnosis criteria are strengthened. Therefore, before the diagnosis criterion is strengthened, the P3 location is diagnosed as a normal state, but after the diagnosis criterion is strengthened, the P3 location may be diagnosed as an abnormal state (warning step).

In this embodiment, the control module 200 may consider the change speed of a corresponding diagnosis item or the change speed of another diagnosis item. For example, in the process of performing charging high-temperature diagnosis as in the embodiment of FIG. 7, the control module 200 may measure the temperature of the battery during charging at each time and calculate the temperature change speed according to time. At this time, when the temperature change speed, especially the temperature rising speed, is at a certain level or above, the control module 200 may lower the three diagnosis criteria RC1, RC2, and RC3 as indicated by arrows a1, a2, and a3.

Moreover, the diagnosis criterion change according to the change speed of the battery state information may be accomplished in several steps. For example, in the embodiment of FIG. 8, the control module 200 may change the diagnosis criterion RD2 to RD2' or RD2" according to the change speed of the battery state information, for example the current rising speed.

In particular, the control module 200 may compare the current rising speed with two reference current speeds. For example, the two reference current speeds may be VR1 and VR2 (VR1<VR2). At this time, if the current rising speed is greater than the first current speed reference value VR1 and less than the second current speed reference value VR2, the control module 200 may change the diagnosis criterion relatively slightly, like lowering RD2 to RD2'. Meanwhile, if the current rising speed is greater than the second current speed reference value VR2, the control module 200 may change the diagnosis criterion relatively large, like lowering RD2 to RD2".

According to this embodiment of the present disclosure, more efficient diagnosis and processing may be possible depending on the change speed of the battery state information. In particular, as the battery state information changes faster, the abnormal state of the battery may be more likely to become serious or to become worsen within a short period of time. However, according to this embodiment, it is possible to quickly and effectively respond to such a situation.

The measurement module 100 may change the measurement time when measuring the state information of the battery. For example, the measurement module 100 may measure voltage, current, temperature, etc. of the battery, and the measurement may be performed at a specific predetermined time. The measurement module 100 may change the timing of measuring the state information. Moreover, the measurement module 100 may periodically measure specific state information of the battery, and in this case, the measurement cycle may be changed.

Moreover, the measurement module 100 may be configured to change the state information measurement time of the battery according to the diagnosis result of another diagnosis item, for at least some diagnosis items, when diagnosis is performed on a plurality of diagnosis items. In particular, the measurement module 100 may reduce the information measurement time when an abnormal state is diagnosed in the diagnosis result of another diagnosis item, compared to the normal state.

For example, in the embodiment of FIG. 4, the measurement module 100 may periodically measure the voltage of a battery cell as the state information of the battery for the cell overvoltage diagnosis item. In this situation, when an abnormal state such as danger (Warn2) or fault (Fault) is diagnosed in another diagnosis item, such as the pack overvoltage diagnosis item or the charging overcurrent diagnosis item, the measurement module 100 may shorten the voltage measurement cycle for the cell overvoltage diagnosis.

In an embodiment where the measurement module 100 changes the information measurement time by considering the diagnosis result of another diagnosis item, the measurement module 100 may receive the diagnosis result of another diagnosis item from the control module 200. In addition, the measurement module 100 may change the state information measurement time of the battery according to the diagnosis result of another diagnosis item transmitted from the control module 200.

Alternatively, the measurement time change of the measurement module 100 may be performed under the control of the control module 200. For example, the control module 200 may transmit a control signal to the measurement module 100 to change the state information measurement time for a specific diagnosis item, considering the diagnosis result of another diagnosis item. Then, the measurement module 100 may change the state information measurement time according to the control signal transmitted from the control module 200 in this way.

As a more specific example, the measurement module 100 may measure the voltage of a battery cell at every 0.02 seconds (s) for the cell overvoltage diagnosis. That is, the cell voltage measurement period may be 0.02 seconds. However, for another diagnosis item other than the cell overvoltage diagnosis, such as the pack overvoltage diagnosis or the charging overcurrent diagnosis, information that the diagnosis is in at least one abnormal step among the warning/danger/fault/failure steps may be transmitted to the measurement module 100 from the control module 200. In this case, the measurement module 100 may shorten the voltage measurement cycle of the battery cell.

In particular, the measurement module 100 may change the measurement time differently depending on the diagnosis step of another diagnosis item. Moreover, as the abnormal state of another diagnosis item worsens, the measurement time may be further shortened.

For example, if the warning (Warn1) step is diagnosed in the pack overvoltage diagnosis item, the measurement module 100 may shorten the voltage measurement cycle for the cell overvoltage diagnosis by 0.002 seconds from 0.02 seconds to 0.018 seconds. As another example, if the danger (Warn2) step is diagnosed in the pack overvoltage diagnosis item, the measurement module 100 may shorten the voltage measurement cycle for the cell overvoltage diagnosis by 0.005 seconds from 0.02 seconds to 0.015 seconds.

In addition, the measurement module 100 may change the state information measurement time by considering the number of diagnosis items diagnosed as an abnormal state. In particular, the measurement module 100 may further shorten the measurement time when the number of diagnosis items diagnosed as an abnormal state is larger than the case where the number of diagnosis items is small.

For example, if an abnormal state is diagnosed in diagnosis items exceeding the standard number among various other diagnosis items (pack overvoltage diagnosis, charging overcurrent diagnosis, charging high-temperature diagnosis, etc.), compared to the case where an abnormal state is diagnosed in diagnosis items less than the standard number, the measurement module 100 may shorten the voltage measurement time. As a more specific example, when the warning step or higher is diagnosed in less than three diagnosis items, the measurement module 100 may shorten the voltage measurement cycle for the cell overvoltage diagnosis by 0.005 seconds from 0.02 seconds to 0.015 seconds. Meanwhile, if a warning step or higher is diagnosed in three or more other diagnosis items, the measurement module 100 may significantly shorten the voltage measurement cycle for the cell overvoltage diagnosis by 0.01 seconds from 0.02 seconds to 0.01 seconds.

According to this embodiment of the present disclosure, since the state information measurement time of the battery is changed by considering the diagnosis results of other diagnosis items, more efficient diagnosis and response may be possible. In particular, in a normal situation, the measurement frequency may be be lowered to reduce resource consumption due to measurement, and in an abnormal situation or a situation where there is a high probability that such an abnormal situation will occur or worsen, the measurement frequency may be increased to enable more rapid measurement. Moreover, if an abnormal diagnosis is made in another diagnosis item, an abnormal diagnosis is more likely to be made in other related items, so diagnosis and response may be made more quickly by changing the measurement frequency or cycle.

Meanwhile, in this embodiment, it has been described that the state information measurement time for a specific diagnosis item is changed by considering the diagnosis result of another diagnosis item, but the measurement module 100 may also change the measurement time according to the diagnosis result of the corresponding diagnosis item. In particular, the measurement module 100 may shorten the voltage measurement time or cycle when the abnormal state of the corresponding diagnosis item progresses more seriously.

For example, basically, the voltage measurement cycle for the cell overvoltage diagnosis item may be 0.02 seconds. However, if the cell overvoltage diagnosis item is diagnosed as in the warning (Warn1) step, the voltage measurement cycle by the measurement module 100 may be shortened to 0.017 seconds. In addition, when the cell overvoltage diagnosis item is diagnosed as in the danger (Warn2) step, the voltage measurement cycle by the measurement module 100 may be shortened to an even greater level of 0.014 seconds. Moreover, if the cell overvoltage diagnosis item is diagnosed as in the fault (Fault) step, the voltage measurement cycle by the measurement module 100 may be shortened to a much greater level of 0.010 seconds.

According to this embodiment, diagnosis and respond may be made to the relevant diagnosis items as quickly and accurately as possible before progressing to a serious situation such as failure diagnosis.

The control module 200 may be configured to classify processing operations according to whether different diagnosis steps can be automatic released. Here, the automatic release may mean that the control module 200 changes the diagnosis step on its own after the control module 200 determines the diagnosis step.

In particular, the control module 200 may diagnose the abnormal state in multiple stages for a specific diagnosis item. At this time, the control module 200 may be configured to enable automatic release for some diagnosis steps and to disable automatic release for other diagnosis steps.

For example, when the cell overvoltage diagnosis item as shown in FIG. 6 is diagnosed in 4 steps of warning/danger/fault/failure, the control module 200 may be configured to enable automatic release of the warning and danger steps. At this time, the control module 200 diagnoses the warning step or the danger step since the measurement value or the calculation value exceeds the corresponding diagnosis criterion, but if the measurement value or the calculation value falls below the diagnosis criterion again, the control module 200 may release the warning step or the danger step on its own. As a more specific example, even if the charging high-temperature diagnosis is diagnosed as the warning step or the danger step, if the temperature drops, the control module 200 may release the warning step or the danger step to convert it to a normal step or lower the abnormal step to a warning step.

Meanwhile, the control module 200 may be configured so that automatic release is not possible for the fault and failure steps. In other words, if the measurement value or the calculation value exceeds the corresponding diagnosis criterion and is diagnosed as a fault step or failure step, the control module 200 may not be configured to release the fault step or the failure step on its own even if the related measurement value or calculation value falls below the diagnosis criterion. In this case, the diagnosis situation of the fault step or the failure step may be released by a device or system other than the apparatus for managing a battery according to the present. For example, if diagnosis made as a fault step, the situation may be released only upon a request from a higher-level system such as ECU or VCU. Moreover, if diagnosis is made as a failure step, the situation cannot be released even by a request from a higher-level system, and can only be released after an inspection of the battery or the apparatus for managing a battery is performed at a service center, etc.

In addition, the control module 200 may be configured to classify processing operations into output restriction and output blocking for the battery for different diagnosis steps. Here, the output restriction may mean that the battery can be charged or discharged but the size of the charging and discharging voltage or current is reduced or the charging and discharging time is reduced. Also, the output blocking may mean that charging or discharging itself is stopped.

For example, the control module 200 may perform output restriction for the warning step and the danger step, and perform output blocking for the fault step and the failure step. Moreover, the control module 200 may perform different degrees of output restriction for the warning step and the danger step. For example, the control module 200 may restrict the output to a greater extent in the danger step than in the warning step.

In particular, the control module 200 may perform output restriction and/or output blocking using a switching element such as FET or relay. In addition, the control module 200 may perform all of the output restriction and/or output restriction operations, or a higher-level system such as a system at the vehicle may share at least some of the operations.

In addition, the control module 200 may perform different processing operations for different diagnosis items, even if their abnormal steps are at the same level. For example, if the cell overvoltage item is diagnosed as a fault step, the control module 200 may block charging of the corresponding battery cell. As another example, if the cell low voltage item is diagnosed as a fault step, the control module 200 may block discharging of the corresponding battery cell.

In addition, the control module 200 may be configured to classify processing operations as provision of a warning signal and output adjustment for different diagnosis steps. Here, the output adjustment may mean or include output restriction and/or output blocking. In other words, the control module 200 may output a warning signal for some diagnosis steps and adjust the output for some other diagnosis steps.

For example, when the high-temperature diagnosis is diagnosed as a warning step or a danger step, the control module 200 may not perform separate output restriction or blocking for charging and discharging, but may only transmit a warning message to the higher-level system or the user. Meanwhile, when the discharging high-temperature diagnosis is diagnosed as a fault step or a failure step, the control module 200 may perform output restriction or output blocking for charging and discharging.

If diagnosis is performed on a plurality of diagnosis items, the control module 200 may perform comprehensive diagnosis by considering the diagnosis results for the plurality of diagnosis items. For example, the control module 200 may perform comprehensive diagnosis as the overall evaluation result of the battery. At this time, the comprehensive diagnosis result may also be provided in multiple stages, for example four stages (warning/danger/fault/failure).

A battery pack according to the present disclosure may include the apparatus for managing a battery according to the present disclosure described above. The battery pack according to the present disclosure includes, in addition to the apparatus for managing a battery according to the present disclosure, components typically included in the battery pack, such as a battery cell, a pack housing, and electronic components such as a fuse, a relay and a BMS. Moreover, at least some functions, configurations, operations, etc. of the apparatus for managing a battery according to the present disclosure may be implemented by a BMS or various sensors included in the battery pack.

In addition, the battery pack according to the present disclosure may be a public exchangeable battery pack for a vehicle, especially an electric two-wheeled vehicle. Also, the apparatus for managing a battery according to the present disclosure may be mounted on such a public exchangeable battery pack for an electric two-wheeled vehicle.

In addition, a vehicle according to the present disclosure may include the apparatus for managing a battery according to the present disclosure or the battery pack according to the present disclosure. Moreover, the vehicle according to the present disclosure may be powered by electricity and may include a battery pack for driving. At this time, the apparatus for managing a battery according to the present disclosure may be prepared entirely at the battery pack. Alternatively, the apparatus for managing a battery according to the present disclosure may be prepared in a form in which some functions or configurations are shared between the battery pack and the vehicle. For example, most of the operations or functions of the control module 200 are performed by the BMS of the battery pack, but some operations or functions may be implemented by a higher-level system at the vehicle, such as an ECU or VCU.

Also, the vehicle according to the present disclosure may further include other components generally applied to the vehicle, in addition to the apparatus for managing a battery or battery pack. In particular, the vehicle according to the present disclosure may be an electric two-wheeled vehicle.

In addition, a battery providing system according to the present disclosure may include the apparatus for managing a battery according to the present disclosure. Here, the battery providing system may be a concept that includes a battery charging system that provides a charging service for a discharged battery, or a battery exchange system that provides a service for exchanging a discharged battery with a charged battery. Also, the battery providing system may include a battery inspection and repair system, such as a service center that repairs or inspects the battery. Also, the battery providing system may include a battery sales system that allows users to purchase batteries.

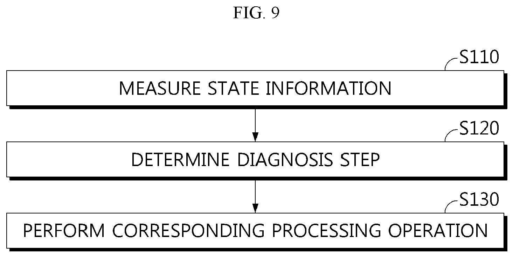

FIG. 9 is a flowchart for schematically illustrating a method for managing a battery according to an embodiment of the present disclosure. In FIG. 9, the subject performing each step may be a component of the apparatus for managing a battery according to the present disclosure.

Referring to FIG. 9, the method for managing a battery according to the present disclosure may include a state information measurement step (S110), a diagnosis step (S120), and a corresponding processing operation performance step (S130).

First, the state information measurement step (S110) may be a step that measures state information of a battery. S110 step may be performed by the measurement module 100. Also, for S110 step, various explanations, such as the function or operation of the measurement module 100 described above, may be applied.

Next, the diagnosis step determination step (S120) may be performed to determine a diagnosis step for the battery by comparing the state information of the battery measured in step S110 with a diagnosis criterion of a multistage form. S120 step may be performed by the control module 200 of the apparatus for managing a battery. Also, for S120 step, various explanations for the diagnosis configuration of the control module 200 described above may be applied.

In addition, the corresponding processing operation performance step (S130) may perform a processing operation corresponding to the diagnosis step determined in step S120. S130 step may also be performed by the control module 200. Accordingly, for S130, various descriptions of the processing operation performance configuration of the control module 200 described above may be applied. Alternatively, at least some operations of step S130 may be performed by the measurement module 100. For example, in step S130, the state information measurement time of the battery may be changed as a corresponding processing operation.

In addition, the method for managing a battery according to the present disclosure will not be described in detail because the features of the apparatus for managing a battery according to the present disclosure described in detail above may be applied thereto in a similar or similar manner.

### Reference Signs

100: measurement module
200: control module
300: memory

## Claims

1. An apparatus for managing a battery, comprising:
a measurement module (100) configured to measure state information (S110) of a battery; and
a control module (200) configured to determine a diagnosis step (S120) of the battery by comparing the state information measured by the measurement module (100) with a diagnosis criterion of a multistage form (R1, R2, R3, R4) and to perform a processing operation (S130) corresponding to the determined diagnosis step,
**characterized in that**:
the control module (200) is configured to classify an abnormal state of the battery into a plurality of diagnosis steps,
the control module (200) is configured to classify the processing operation as output restriction of the battery and output blocking of the battery for different diagnosis steps or classify the processing operation as provision of a warning signal and output adjustment for different diagnosis steps.

2. The apparatus for managing a battery according to claim 1, further comprising:
a memory (300) configured to store the diagnosis criterion of a multistage form (R1, R2, R3, R4).

3. The apparatus for managing a battery according to claim 1,
wherein the control module (200) is configured to determine the diagnosis step (S120) for a plurality of diagnosis items.

4. The apparatus for managing a battery according to claim 3,
wherein the battery is configured in the form of a battery pack including a plurality of battery cells, and
wherein the control module (200) is configured to perform overvoltage diagnosis and low voltage diagnosis for at least some of the plurality of battery cells or the entire battery pack as the plurality of diagnosis items.

5. The apparatus for managing a battery according to claim 3,
wherein the control module (200) is configured to perform diagnosis at charging and diagnosis at discharging for at least one of current and temperature of the battery as the plurality of diagnosis items.

6. The apparatus for managing a battery according to claim 3,
wherein the control module (200) is configured to perform inter-cell voltage imbalance diagnosis during charging and inter-cell voltage imbalance diagnosis during idle as the plurality of diagnosis items.

7. The apparatus for managing a battery according to claim 3,
wherein the control module (200) is configured to change the diagnosis criterion for at least some of the plurality of diagnosis items according to a diagnosis result of another diagnosis item.

8. The apparatus for managing a battery according to claim 3,
wherein the measurement module (100) is configured to change state information measurement time of the battery for at least some of the plurality of diagnosis items according to a diagnosis result of another diagnosis item.

9. The apparatus for managing a battery according to claim 1,
wherein the control module (200) is configured to classify the processing operation according to whether automatic release is possible for different diagnosis steps.

10. A battery pack, comprising the apparatus for managing a battery according to any one of claims 1 to 9.

11. A vehicle, comprising the apparatus for managing a battery according to any one of claims 1 to 9.

12. A battery providing system, comprising the apparatus for managing a battery according to any one of claims 1 to 9.

13. A method for managing a battery, comprising:
measuring state information (S110) of a battery;
determining a diagnosis step (S120) of the battery by comparing the measured state information with a diagnosis criterion of a multistage form (R1, R2, R3, R4); and
performing a processing operation (S130) corresponding to the diagnosis step determined in the determining step,
**characterised in that** the method further comprises:
classifying an abnormal state of the battery into a plurality of diagnosis steps, and
classifying the processing operation as output restriction of the battery and output blocking of the battery for different diagnosis steps or classifying the processing operation as provision of a warning signal and output adjustment for different diagnosis steps.

## Patentansprüche

1. Vorrichtung zur Verwaltung einer Batterie, umfassend:
ein Messmodul (100), das konfiguriert ist, um Zustandsinformationen (S110) einer Batterie zu messen; und
ein Steuermodul (200), das konfiguriert ist, um einen Diagnoseschritt (S120) der Batterie durch Vergleichen der vom Messmodul (100) gemessenen Zustandsinformationen mit einem Diagnosekriterium einer mehrstufigen Form (R1, R2, R3, R4) zu bestimmen und einen Verarbeitungsvorgang (S130) durchzuführen, der dem bestimmten Diagnoseschritt entspricht,
**dadurch gekennzeichnet, dass**:
das Steuermodul (200) konfiguriert ist, um einen anormalen Zustand der Batterie in eine Vielzahl von Diagnoseschritten zu klassifizieren,
das Steuermodul (200) konfiguriert ist, um den Verarbeitungsvorgang als Ausgangsbeschränkung der Batterie und Ausgangssperrung der Batterie für verschiedene Diagnoseschritte zu klassifizieren oder den Verarbeitungsvorgang als Bereitstellung eines Warnsignals und Ausgangsanpassung für verschiedene Diagnoseschritte zu klassifizieren.

2. Die Vorrichtung zur Verwaltung einer Batterie nach Anspruch 1, ferner umfassend:
einen Speicher (300), der konfiguriert ist, um das Diagnosekriterium einer mehrstufigen Form (R1, R2, R3, R4) zu speichern.

3. Die Vorrichtung zur Verwaltung einer Batterie nach Anspruch 1,
wobei das Steuermodul (200) konfiguriert ist, um den Diagnoseschritt (S120) für eine Vielzahl von Diagnoseelementen zu bestimmen.

4. Die Vorrichtung zur Verwaltung einer Batterie nach Anspruch 3,
wobei die Batterie in Form eines Batteriepacks konfiguriert ist, das eine Vielzahl von Batteriezellen enthält, und
wobei das Steuermodul (200) konfiguriert ist, um eine Überspannungsdiagnose und eine Unterspannungsdiagnose für mindestens einige der Vielzahl von Batteriezellen oder den gesamten Batteriepack als die Vielzahl von Diagnoseelementen durchzuführen.

5. Die Vorrichtung zur Verwaltung einer Batterie nach Anspruch 3,
wobei das Steuermodul (200) konfiguriert ist, um eine Diagnose beim Laden und eine Diagnose beim Entladen für mindestens eines von Strom und Temperatur der Batterie als die Vielzahl von Diagnoseelementen durchzuführen.

6. Die Vorrichtung zur Verwaltung einer Batterie nach Anspruch 3,
wobei das Steuermodul (200) konfiguriert ist, um eine Diagnose eines Spannungsungleichgewichts zwischen den Zellen während des Ladens und eine Diagnose eines Spannungsungleichgewichts zwischen den Zellen im Leerlauf als die Vielzahl von Diagnoseelementen durchzuführen.

7. Die Vorrichtung zur Verwaltung einer Batterie nach Anspruch 3,
wobei das Steuermodul (200) konfiguriert ist, um das Diagnosekriterium für mindestens einige der Vielzahl von Diagnoseelementen gemäß einem Diagnoseergebnis eines anderen Diagnoseelements zu ändern.

8. Die Vorrichtung zur Verwaltung einer Batterie nach Anspruch 3,
wobei das Messmodul (100) konfiguriert ist, um die Messzeit der Zustandsinformationen der Batterie für mindestens einige der Vielzahl von Diagnoseelementen gemäß einem Diagnoseergebnis eines anderen Diagnoseelements zu ändern.

9. Die Vorrichtung zur Verwaltung einer Batterie nach Anspruch 1,
wobei das Steuermodul (200) konfiguriert ist, um den Verarbeitungsvorgang danach zu klassifizieren, ob eine automatische Freigabe für verschiedene Diagnoseschritte möglich ist.

10. Ein Batteriepack, umfassend die Vorrichtung zur Verwaltung einer Batterie nach einem der Ansprüche 1 bis 9.

11. Ein Fahrzeug, umfassend die Vorrichtung zur Verwaltung einer Batterie nach einem der Ansprüche 1 bis 9.

12. Ein Batterieversorgungssystem, umfassend die Vorrichtung zur Verwaltung einer Batterie nach einem der Ansprüche 1 bis 9.

13. Verfahren zur Verwaltung einer Batterie, umfassend:
Messen von Zustandsinformationen (S110) einer Batterie;
Bestimmen eines Diagnoseschritts (S120) der Batterie durch Vergleichen der gemessenen Zustandsinformationen mit einem Diagnosekriterium einer mehrstufigen Form (R1, R2, R3, R4); und
Durchführen eines Verarbeitungsvorgangs (S130), der dem im Bestimmungsschritt bestimmten Diagnoseschritt entspricht,
**dadurch gekennzeichnet, dass** das Verfahren ferner umfasst:
Klassifizieren eines anormalen Zustands der Batterie in eine Vielzahl von Diagnoseschritten, und
Klassifizieren des Verarbeitungsvorgangs als Ausgangsbeschränkung der Batterie und Ausgangssperrung der Batterie für verschiedene Diagnoseschritte oder Klassifizieren des Verarbeitungsvorgangs als Bereitstellung eines Warnsignals und Ausgangsanpassung für verschiedene Diagnoseschritte.

## Revendications

1. Appareil de gestion de batterie, comprenant :
un module de mesure (100) configuré pour mesurer des informations d'état (S110) d'une batterie ; et
un module de commande (200) configuré pour déterminer une étape de diagnostic (S120) de la batterie en comparant les informations d'état mesurées par le module de mesure (100) à un critère de diagnostic de forme multi-étagée (R1, R2, R3, R4) et pour effectuer une opération de traitement (S130) correspondant à l'étape de diagnostic déterminée,
**caractérisé en ce que** :
le module de commande (200) est configuré pour classer un état anormal de la batterie en une pluralité d'étapes de diagnostic,
le module de commande (200) est configuré pour classer l'opération de traitement comme une restriction de sortie de la batterie et un blocage de sortie de la batterie pour différentes étapes de diagnostic ou pour classer l'opération de traitement comme la fourniture d'un signal d'avertissement et un ajustement de sortie pour différentes étapes de diagnostic.

2. L'appareil de gestion de batterie selon la revendication 1, comprenant en outre :
une mémoire (300) configurée pour stocker le critère de diagnostic de forme multi-étagée (R1, R2, R3, R4).

3. L'appareil de gestion de batterie selon la revendication 1,
dans lequel le module de commande (200) est configuré pour déterminer l'étape de diagnostic (S120) pour une pluralité d'éléments de diagnostic.

4. L'appareil de gestion de batterie selon la revendication 3,
dans lequel la batterie est configurée sous la forme d'un bloc-batterie incluant une pluralité de cellules de batterie, et
dans lequel le module de commande (200) est configuré pour effectuer un diagnostic de surtension et un diagnostic de sous-tension pour au moins certaines de la pluralité de cellules de batterie ou la totalité du bloc-batterie en tant que pluralité d'éléments de diagnostic.

5. L'appareil de gestion de batterie selon la revendication 3,
dans lequel le module de commande (200) est configuré pour effectuer un diagnostic à la charge et un diagnostic à la décharge pour au moins l'un du courant et de la température de la batterie en tant que pluralité d'éléments de diagnostic.

6. L'appareil de gestion de batterie selon la revendication 3,
dans lequel le module de commande (200) est configuré pour effectuer un diagnostic de déséquilibre de tension inter-cellules pendant la charge et un diagnostic de déséquilibre de tension inter-cellules au repos en tant que pluralité d'éléments de diagnostic.

7. L'appareil de gestion de batterie selon la revendication 3,
dans lequel le module de commande (200) est configuré pour changer le critère de diagnostic pour au moins certains de la pluralité d'éléments de diagnostic en fonction d'un résultat de diagnostic d'un autre élément de diagnostic.

8. L'appareil de gestion de batterie selon la revendication 3,
dans lequel le module de mesure (100) est configuré pour changer le temps de mesure des informations d'état de la batterie pour au moins certains de la pluralité d'éléments de diagnostic en fonction d'un résultat de diagnostic d'un autre élément de diagnostic.

9. L'appareil de gestion de batterie selon la revendication 1,
dans lequel le module de commande (200) est configuré pour classer l'opération de traitement selon qu'une libération automatique est possible pour différentes étapes de diagnostic.

10. Bloc-batterie, comprenant l'appareil de gestion de batterie selon l'une quelconque des revendications 1 à 9.

11. Véhicule, comprenant l'appareil de gestion de batterie selon l'une quelconque des revendications 1 à 9.

12. Système de fourniture de batterie, comprenant l'appareil de gestion de batterie selon l'une quelconque des revendications 1 à 9.

13. Procédé de gestion de batterie, comprenant :
la mesure d'informations d'état (S110) d'une batterie ;
la détermination d'une étape de diagnostic (S120) de la batterie en comparant les informations d'état mesurées à un critère de diagnostic de forme multi-étagée (R1, R2, R3, R4) ; et
l'exécution d'une opération de traitement (S130) correspondant à l'étape de diagnostic déterminée dans l'étape de détermination,
**caractérisé en ce que** le procédé comprend en outre :
la classification d'un état anormal de la batterie en une pluralité d'étapes de diagnostic, et
la classification de l'opération de traitement comme une restriction de sortie de la batterie et un blocage de sortie de la batterie pour différentes étapes de diagnostic ou la classification de l'opération de traitement comme la fourniture d'un signal d'avertissement et un ajustement de sortie pour différentes étapes de diagnostic.
